# EUROPEAN PATENT APPLICATION

(11) **EP 1 367 872 A2**
(43) Date of publication of application: **03.12.2003**
(21) Application number: 03253328.3
(22) Date of filing: 28.05.2003
(51) Int. Cl.: H05K 3/18, C23C 18/16

(54) **Laser-activated dielectric material and method for using the same in an electroless deposition process**

(30) Priority: 31.05.2002 GB 0212632
(71) Applicant: Shipley Co. L.L.C., Marlborough, MA 01752 (US)
(72) Inventor: Goosey, Martin, Nuneaton, Warwickshire CV10 9NZ (GB); Albin, David, Bath & N.E. Somerset, BS39 6HY (GB); Bains, Narinder, Featherstone, Wolwerhampton WV10 7SX (GB); Christoph, Frank, 90542 Eckental (DE); Ditel, Claudia, 91058 Erlangen (DE); Graves, John, Nuneaton, Warwickshire CV11 6LU (GB); Guyon, Pierre, 57365 Ennery (FR); Jarque, Manuel Garcia, 08292 Esparreguera (ES); Lucas, Jean-Pierre, 57070 Metz (FR); Rossi, Stephanie Grosmaire, 57950 Montigny les Metz (FR); Smeets, Frank, 6983 HM Doesburg (NL)
(74) Representative: Kent, Venetia Katherine

(57) **Abstract**

A method for forming an electrical interconnect structure for a substrate utilizes a dielectric material containing an inorganic filler therein. When the dielectric material is subjected to laser energy, it is simultaneously ablated and activated, thereby catalyzing the deposition of a full-build electroless copper layer thereupon.

## Description

### BACKGROUND

The present invention relates generally to printed circuit board (PCB) manufacturing and, more particularly, to a laser-activated dielectric material and method for using the same in an electroless deposition process.

Printed circuit boards (PCB) perform several indispensable functions in electronic devices of all kinds. For example, individual electrical and electronic components (such as specially packaged integrated circuits, resistors, capacitors, etc.) are mounted or carried on the surface of the flat, usually sturdy, card-like circuit board. Thus, the PCB serves as a unitary mechanical support for the electrical components. In addition, through the use of chemically etched or plated conductor patterns on the board's surface, the PCB facilitates the desired electrical connections between the electrical components. Furthermore, the PCB may additionally include metal areas that serve as heat sinks for high power or thermally sensitive components.

As the use of integrated circuits has grown, the resulting higher density of connections between components has resulted in double-sided PCB's, in which additional interconnections are made by employing conductor patterns on the other side of the board. This trend has also been extended to boards having many layers of interconnections called multilayer PCB's. The connections from layer to layer are typically made by plated-through holes.

Conductor patterns may be formed by using either a "subtractive" process or an "additive" processes. In a typical subtractive process, a photoresist layer is applied to the copper foil portion of a copper foil-clad epoxy fiberglass substrate. The resist layer is then patterned by exposure to ultraviolet light through a stencil-like film artwork mask. Exposed areas of the photoresist are then polymerized. The unexposed, unpolymerized areas are removed by a chemical developing solution, thus leaving areas of copper having the desired conductor pattern underneath the protective barrier of the remaining polymerized photoresist. The exposed copper is then etched away (hence the term "subtracted"), with the remaining photoresist being removed to expose the conductor pattern.

In contrast, an additive process for forming the conductor pattern starts with an insulating substrate. In one additive approach, a polymer based laminate is used, and throughout which is dispersed a catalyst capable of initiating metal plating on the substrate. Such catalysts typically include palladium-based materials. The catalytic substrate, referred to as a "fully additive base material", is coated with photoresist and patterned as described above. Holes through the resist, formed when the unpolymerized resist is washed away, are then filled with metal using electroless plating techniques. Since the conductors are produced by the addition of metal, rather than subtraction as in etching, the process is called "additive".

Regardless of the particular type of process used in manufacturing PCB interconnects, it is desirable to reduce manufacturing costs while increasing efficiency and throughput.

U.S. Patent 5,599,592 to Laude includes references to a plastic composite containing a polymer and grains of one or oxides. It details a three step process of: (1) irradiating the plastic piece with a laser; (2) autocatalytically depositing a metal without the need for a palladium catalyst; and (3) a thermal processing step to induce diffusion of the deposited metal into the plastic piece. The specific polymers disclosed include polyamide, while the inorganic materials disclosed are oxides of antimony, aluminum, iron, zinc and tin. Concentrations are greater than 1%, with the particle sizes disclosed therein being less than 50 microns. Since no palladium catalyst is used in the metallization process, there is an incubation time before substantial metal deposition occurs. This effectively reduces the overall plating rates by a significant amount.

In a paper published in Applied Physics A (67, 303-311, 1998), G.A. Shafeev reported work on the "Laser assisted activation of dielectrics for electroless metal plating". Materials reported as laser activatable included alumina, silicon carbide, zirconia, ceria and diamond. The metals deposited on activated areas included copper, nickel, platinum and palladium. Various laser wavelengths were mentioned including 193, 248, and 308nm. The work concentrated on the use of pure ceramic samples and excludes the possibility of activating powders dispersed in polymers.

In a paper entitled "Influence of Laser Wavelength on Activation of ZrO₂ Ceramics for Electroless Metal Plating", published in Advanced Materials for Optics and Electronics (Vol. 7, 249-254 (1997)), Shafeev et al. examined at the modification of zirconia ceramic surfaces using both KrF (248nm) and ArF (193nm) lasers with pulse durations of 15-20ns. They investigated a variety of laser conditions and reported that, under suitable conditions, laser treated surfaces were catalytic towards copper and nickel deposition. The activation of zirconia ceramics with a low power CW CO₂ laser operating at 10.6 microns was also reported.

In 1998, Stolz B. et al (including Shafeev again), published a paper called "Electroless Cu Plating of Alumina Treated with CW CO₂ Laser Radiation". This work also appeared in the proceedings of the SPIE conference on Smart Electronics and MEMS, San Diego, USA, California, March 1998 (SPIE vol. 3328). The disclosure utilizes 10.6 micron, infra-red radiation rather than a UV laser. However, the main disadvantage of this work is that the alumina has to be exposed while immersed in ethanol in order to impart subsequent catalytic activity towards copper deposition.

Shafeev has also reported work on the 'laser etching' and metallization of both silicon carbide and sapphire ceramics using a copper vapor laser operating at 510nm. Again, this work has utilized a variety of absorbing media that are claimed to enhance the efficiency of the process (see, for example, Applied Surface Science 109/110 (1997) pages 201-205, Dolgaev, S.I., Shafeev, G. A., et al).

### BRIEF SUMMARY

The above discussed and other drawbacks and deficiencies of the prior art are overcome or alleviated by a method for forming an electrical interconnect structure for a substrate. In an exemplary embodiment, the method includes coating the substrate with a dielectric material and then removing selected areas of the dielectric material by application of laser energy thereto. A region for the addition of metallization is thereby defined therein, and a conductive metal is then electrolessly deposited within the region. The application of laser energy also activates the dielectric material to catalyze the deposition of the conductive metal to a full build.

In a preferred embodiment, the dielectric material includes an organic dielectric material with an inert inorganic filler, the inorganic filler being activated by the application of laser energy to the dielectric material, thereby catalyzing the deposition of the conductive metal.

### DETAILED DESCRIPTION

Disclosed herein is a novel, high-density interconnection fabrication process that is shorter, less expensive and more environmentally friendly as compared to existing processes. The process utilizes specially formulated dielectric materials containing "latent catalyst" fillers therein. When such a dielectric material is subjected to laser energy, it is simultaneously ablated and activated, thereby catalyzing the deposition of a full-build electroless copper layer thereupon.

The subsequent exposure to a new plating process involving a sensitizer solution and a full build electroless copper allows circuitry to be deposited in laser ablated grooves and vias formed in the substrate. The process may thereafter be repeated as necessary to generate multilayer interconnects.

A novel dielectric coating contains a latent inert additive that becomes catalytic to electroless metal deposition after exposure to a laser beam of an appropriate wavelength and energy. More specifically, the dielectric used in interconnect formation process is an organic material (e.g., an epoxide resin based polymer) or, alternatively, a non-crystalline inorganic material (e.g., glass). In either case, the dielectric is also filled with an optimized quantity of a specially selected, laser-activated inorganic filler. Suitable examples of the inorganic filler include titanium dioxide (TiO₂), aluminum nitride (AlN), zirconium dioxide (ZrO₂) or combinations thereof. For example, a mixture of aluminum nitride and titanium dioxide might be used to tailor the dielectric properties for a specific application, such as enhanced thermal conductivity.

Although these three materials have been shown to exhibit catalytic activity towards the deposition of copper from an aqueous solution, it will be understood that the present invention embodiments are not specifically limited to the use of these three inorganic materials alone or in combination. It is anticipated that other, similar inorganic materials may also be made to exhibit catalytic activity towards copper deposition, under suitable exposure conditions. It will further be understood that although the present PCB interconnect fabrication process focuses on copper as the deposited interconnect material, the deposition of other metals (such as nickel) is contemplated by the invention, and may even be preferred for certain applications.

In an exemplary interconnect fabrication process, a PCB substrate includes a first level of circuitry defined thereupon. Then a dielectric (as described above) is coated onto the first level of circuitry and the substrate. The material for the substrate may be chosen from a wide range of materials, and is not particularly important for the operation of the subsequent process steps. One possibility, however, for the substrate is an inorganic material such as glass. For most applications of the present technology, it is desirable to ensure good adhesion of the novel dielectric coating to the underlying substrate material. Thus, a suitable surface treatment stage may be implemented. The particular surface treatment will vary, depending upon the substrate material and the chemistry of the dielectric coating.

The dielectric may be coated onto the substrate by a variety of appropriate techniques; again, the particular method of coating will be selected based on the application. In one embodiment, the dielectric is deposited onto a conventionally patterned FR4 copper clad epoxide laminate material, in which the copper has been subjected to a standard oxide or reduced oxide process. The oxide process serves to enhance adhesion between the dielectric and the patterned copper circuitry on the substrate. This early substrate preparation and coating stage is based on standard PCB manufacturing practices and will be familiar to one skilled in the art. Several variations of this surface treatment stage are in existence, and can be used in conjunction with the present invention embodiments.

A preferred method of coating the dielectric onto the substrate is through the use of screen printing. However, other methods are equally applicable including, but not limited to: spraying, curtain coating and roller coating, or dry film lamination. The method of coating is not limited to these cited examples, and any other techniques can be utilized so long as they are capable of providing a consistent, pinhole-free dielectric film having good thickness uniformity over the size of the chosen substrate. An exemplary dielectric coating thickness ranges from 10 to 100 microns (µm), with a preferred range for advanced interconnect manufacture being from 30 to 50 µm. In any case, there should be a sufficient thickness of dielectric formed over any patterned copper tracks to provide satisfactory electrical insulation, dielectric properties and separation of conductors.

The organic component of the dielectric coating may be based upon a wide range of polymer chemistries, with the specific choice being dependent on the final application and properties desired. For example, one particular dielectric has been formulated that uses a two-part epoxide resin based chemistry, representative of the type of material that is ordinarily used in electronic interconnection and packaging applications. Alternatively, the organic component may be based other polymer chemistries, such as epoxide-acrylates, polyimides, or silicones.

In addition to the epoxide-based organic component of the dielectric, there is also an additional inorganic component that is initially inert, but which is subsequently modified by laser exposure to become a catalyst for the electroless deposition of a metal (e.g., copper). Again, suitable examples of the inorganic materials include titanium dioxide (TiO₂), aluminum nitride (A1N) and zirconium dioxide (ZrO₂). The inorganic material is milled into the dielectric at the formulation stage thereof, with typical loading levels ranging up to (or from 5% to) 60% by weight (w/w). A typical particle size for these materials may range from 0.01 up to 20 µm, with preferred values being between 0.5 and 5 µm. Both the loading level and the particle size distribution were found to have some influence on subsequent catalytic activity, and thus each parameter is optimized for a specific application and set of subsequent processing conditions.

### EXAMPLE 1

Preferred filler loadings for titanium dioxide in the above-described epoxide matrix were in the region of 45% (w/w), although catalytic activity was also developed at other loading levels. The dielectric was coated using conventional screen printing and, after drying, was cured at temperatures between 110°C and 140°C for 10 to 40 minutes. The preferred curing conditions in this instance are 140°C for 30 minutes, since increasing the temperature reduces the curing time and shortens the process. While these curing conditions are typical for the example cited, it is reasonable to expect that other materials may require a broader range of curing conditions. The curing range is not particularly relevant to the present invention, although it may need to be optimized in combination with the subsequent laser ablation conditions in order to determine the preferred laser ablation characteristics for a given application.

Once the substrate and circuitry has been coated, the dielectric may then be patterned by imaging tracks and/or ablating grooves and vias using a suitable energy source such as laser. In the electronics industry, lasers are widely employed, while various commercial machines are available for "drilling" materials. However, a characteristic of the present disclosure is the ability to both specifically irradiate and/or ablate selected areas of the dielectric while simultaneously activating the inorganic filler such that it becomes catalytic to electroless copper deposition. A wide range of lasers are suitable for this process and, by way of example, lasers operating in both the infrared and ultraviolet regions of the electromagnetic spectrum have been successfully utilized. Examples of specific lasers used in the ablation/activation process include a neodymium:YAG laser at an output wavelength of 355 nanometers (nm), an excimer laser at 248 nm, and a carbon dioxide laser working at 9400 nm. The imaging and/or ablation/activation process can be optimized by varying the amount of energy applied to the substrate. Patterns are generated on the substrate using a suitable computer controlled x-y translation table or other commercially available beam deflecting/sample movement system. The depth of the tracks as imaged and/or ablated, as well as the depth of the vias is managed through software control by varying, for example, the beam energy, exposure time, or number of pulses.

Examples of typical laser exposure conditions capable of simultaneously ablating and activating the dielectric are shown below for a krypton fluoride laser operating at 303 nm with a pulse energy of 300 millijoules (mJ):

| Beam energy per unit area/mJ/cm² | Pulse range for ablation and activation |
|---|---|
| 80 | 50 to 100 |
| 120 | 50 to 1000 |
| 150 | 50 to 1000 |
| 200 | 3 to 1000 |
| 250 | 3 to 1000 |
| 500 | 3 to 1000 |

The process simultaneously images and/or ablates and activates the dielectric to form channels that can be subsequently plated using, for example, a full build electroless copper or other suitable metals such as nickel.

Although full build electroless copper processes have been well known in the art for some years, they traditionally suffer from complex chemistries and slow plating rates. Accordingly, a further aspect of the present invention is the addition of a sensitizing predip prior to the full build electroless copper. The sensitizing predip allows for a faster plating rate, featuring fewer chemistry components and an easier to control process. The sensitizer chemistry is based on a metal containing solution which may be, for example, silver-based or cobalt-based. With the use of a sensitizing predip, the laser activation process window is significantly broadened, and thus the plating becomes more efficient.

In a preferred metallization process, a full build electroless copper is used to deposit about 15 µm of copper using process conditions described hereinafter. The plating rate for the copper is approximately 3.5 µm per hour. In order to form a full build deposit in accordance with existing printed circuit demands, the plating is allowed to continue for several hours to result in a deposit of around 15 µm.

| Process step | Time/min | Temp/°C |
|---|---|---|
| Metal-based sensitizing predip | 5 | 60 |
| Rinse | 4 | Room |
| Electroless copper 4750 | 60 | 60 |
| Rinse | 4 | Room |

It will be appreciated that the process conditions shown above are given by way of example, and the many other variations of the build process are possible using alternative plating rates, copper chemistries and even other metal deposition solutions.

Once an initial full build electroless copper deposition completed, an additional metallization layer may be constructed following a second coating of dielectric material. As with the first coating, the second dielectric coating is ablated and activated to define the next series of trenches and vias for a subsequent electroless deposition step. The process is repeated as often as needed.

In another method embodiment, a double coating of dielectric was used. That is, a second dielectric layer was deposited on top of a first dielectric layer to result in a desired thickness. However, the first and second dielectric layers were of different formulations in order to enhance the process. More specifically, the first dielectric layer included an organic dielectric with an inorganic titanium dioxide filler, such as described earlier. The second dielectric layer, in addition to the inorganic filler material, also included carbon black. The carbon was added as an enhancer to increase the laser ablation rate of the second (top) dielectric layer. Thus, once the second layer was ablated through, the ablation rate decreased when the first (bottom) dielectric layer was reached. In effect, the first layer acted as an "ablation stop" or an end point detector for the ablation of the second dielectric layer, thereby proving useful in the formation of vias therein.

Finally, it will be appreciated that the above described laser-activated dielectric material and associated electroless deposition process may have applicability beyond the scope of PCB manufacturing. For example, it is envisioned that the presently disclosed method may be implemented in other areas such as selective electromagnetic interference (EMI) shielding or, in general, in any applications involving metal plating upon plastic surfaces.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A method for forming an electrical interconnect structure for a substrate, the method comprising:
coating the substrate with a dielectric material;
activating said dielectric material by application of laser energy thereto, thereby catalyzing the deposition of a conductive metal thereon;
said application of laser energy further removing selected areas of said dielectric, thereby defining a region for the addition of metallization therein; and
electrolessly depositing a conductive metal within said region to a full build.

2. The method of claim 1, wherein said dielectric material comprises an organic dielectric material with an inorganic filler, said inorganic filler being activated by said application of laser energy to said dielectric material, thereby catalyzing said deposition of said conductive metal.

3. The method of claim 2, wherein said organic dielectric material is based on a polymer chemistry selected from the group of: two-part epoxide, epoxide-acrylates, polyimides, and silicones.

4. The method of claim 1, wherein said dielectric material comprises a non-crystalline, inorganic dielectric material with an inorganic filler, said inorganic filler being activated by said application of laser energy to said dielectric material, thereby catalyzing said deposition of said conductive metal.

5. The method of claim 4, wherein said non-crystalline, inorganic material comprises glass.

6. The method of any one of claims 2 to 5, wherein said inorganic filler is selected from the group of: titanium dioxide, zirconium dioxide, aluminum nitride and combinations comprising at least one of the foregoing.

7. The method of any one of claims 1 to 5, wherein said laser energy is applied through an excimer laser, a neodymium:yttrium aluminum garnet (YAG) laser or a carbon dioxide laser.

8. The method of any one of claims 1 to 7, wherein said conductive metal is selected from the group of any metals that may be deposited from solution using an autocatalytic route.

9. The method of claim 2, further comprising:
following said application of laser energy and prior to said deposition of said conductive metal, applying a sensitizer predip to said region;
wherein said sensitizer predip enhances the catalytic activity of said deposition of said conductive metal.

10. The method of claim 9, wherein said sensitizer predip is silver-based or colbalt-based.
